# EUROPÄISCHE PATENTSCHRIFT

(11) **EP 2 520 019 B1**
(45) Veröffentlichungstag und Bekanntmachung des Hinweises auf die Patenterteilung: **06.08.2014**
(21) Anmeldenummer: 10792821.0
(22) Anmeldetag: 30.11.2010
(51) Int. Cl.: H01L 23/66, H01L 23/00, H01L 23/64, H03F 3/193, H03F 3/26

(54) **VERSTÄRKERBAUSTEIN MIT EINEM KOMPENSATIONSELEMENT**
AMPLIFIER COMPONENT COMPRISING A COMPENSATION ELEMENT
COMPOSANT AMPLIFICATEUR COMPORTANT UN ÉLÉMENT DE COMPENSATION

(30) Priorität: 03.03.2010 DE 102010009984; 28.12.2009 DE 102009060669
(43) Veröffentlichungstag der Anmeldung: 07.11.2012
(73) Patentinhaber: Rohde & Schwarz GmbH & Co. KG, 81671 München (DE)
(72) Erfinder: KAEHS, Bernhard, 82008 Unterhaching (DE)
(74) Vertreter: Körfer, Thomas
(86) Internationale Anmeldenummer: PCT/EP2010/007261
(87) Internationale Veröffentlichungsnummer: WO 2011/079899

(56) Entgegenhaltungen:
- WO-A1-00/33378
- WO-A1-2007/003224
- US-A- 3 713 006
- US-A- 4 107 728
- US-A- 4 456 888
- US-A- 5 623 231
- US-A1- 2003 117 219
- US-A1- 2004 145 034
- US-A1- 2007 096 816
- US-A1- 2008 246 547
- TAMMY HO ET AL: "A 900 MHz, 200 W silicon LDMOS power amplifier using integrated passive devices in a new over-molded plastic package", MICROWAVE SYMPOSIUM DIGEST, 2009. MTT '09. IEEE MTT-S INTERNATIONAL, IEEE, PISCATAWAY, NJ, USA, 7. Juni 2009 (2009-06-07), Seiten 1269-1272, XP031490757, ISBN: 978-1-4244-2803-8
- BAKASKI W ET AL: "A fully integrated 4.8-6 GHz power amplifier with on-chip output balun in 38 GHz-fT Si-bipolar", 2003 IEEE MTT-S INTERNATIONAL MICROWAVE SYMPOSIUM DIGEST.(IMS 2003). PHILADELPHIA, PA, JUNE 8 - 13, 2003; [IEEE MTT-S INTERNATIONAL MICROWAVE SYMPOSIUM], NEW YORK, NY : IEEE, US, Bd. 2, 8. Juni 2003 (2003-06-08), Seiten 695-698, XP010645003, DOI: DOI:10.1109/MWSYM.2003.1212467 ISBN: 978-0-7803-7695-3

## Beschreibung

Die Erfindung betrifft einen Verstärkerbaustein, insbesondere einen Hochfrequenzverstärkerbaustein, in einem Chipgehäuse mit einem Kompensationselement, wie er in der Nachrichtentechnik z.B. zur Aussendung von Rundfunk- und Fernsehsignalen, bei Mobilfunkbasisstationen, bei der EMV-Messtechnik und für wissenschaftliche Zwecke zur Erzeugung hoher Hochfrequenzleistungen eingesetzt wird.

Der Verstärkerbaustein ist im Wesentlichen aus Leistungstransistoren aufgebaut, die je nach Anwendungsfall z.B. über mehrere Oktaven betrieben werden sollen. Die Leistung des Transistors ist dabei umso höher, je niedriger der angeschlossene Lastwiderstand ist. Bei Transistorleistungen von z.B. 100 Watt bis z.B. 1000 Watt liegt der Lastwiderstand in einem Bereich von mehreren Ohm bis hin zu unter einem Ohm. Über ein Anpassnetzwerk muss dieser Lastwiderstand auf eine Systemimpedanz von typischerweise 50 Ohm transferiert werden. Am Ausgang des Verstärkerbausteins bildet sich dabei eine parasitäre Kapazität aus, die die Bandbreite dieses Anpassnetzwerks begrenzt. Diese parasitäre Kapazität kann durch ein Kompensationselement, welches ein induktives Verhalten aufweisen muss, kompensiert werden. Ein solches Kompensationselement wird zumeist durch eine kleine Shunt-Induktivität gebildet, die in den Verstärkerbaustein integriert ist.

Aus der US 4,107,728 ist ein Verstärkerbaustein bekannt, der zwei Bipolartransistoren aufweist, die in einer "Push-Pull"-Konfiguration (Gegentakt-Konfiguration) angeordnet sind, wobei beide Transistor-Dies (Transistor-Auflagen), bzw. Transistor-Chips (Halbleiterelementen) in einem gemeinsamen Chipgehäuse (Gehäuse eines Halbleiterverstärkers) untergebracht sind. Die parasitäre Ausgangskapazität bildet sich dabei zwischen der Kollektorfläche und der Bezugsmasse, mit der auch die beiden Emitter verbunden sind. Um diese parasitäre Ausgangskapazität zu kompensieren ist eine Shunt-Induktivität ausgebildet, die beide Kollektorflächen innerhalb des Chipgehäuses miteinander verbindet. Die Shunt-Induktivität selbst wird dabei durch einen dünnen Streifen aus Metall gebildet.

Nachteilig an der US 4,107,728 ist, dass für die Realisierung einer solchen integrierten Shunt-Induktivität größere und teurere Chipgehäuseformen notwendig sind. Desweiteren wird die Shunt-Induktivität in Teilen parallel zu den Bonddrähten geführt, die den Transistor-Die mit den Anschlusspins des Kollektors verbinden, wodurch sich eine Verkopplung ausbildet. Die aus der Verkopplung resultierende Gegeninduktivität wirkt sich nachteilig auf das Kompensationsverhalten aus, wodurch letztendlich die Bandbreite des Anpassnetzwerks sinkt. Außerdem kann eine solche Shunt-Induktivität, die als gedruckte Leitung realisiert wird, nicht direkt auf dem Flansch aufgebracht werden, sondern erfordert eine zusätzliche Isolationsschicht. Eine solche Isolationsschicht, die typischerweise durch eine Keramik oder ein Substrat gebildet wird, ist zwar beim Einsatz von bipolaren Transistoren oder DMOS-Transistoren (diffused metal oxide semiconductor; diffundierter Metall-Oxid-Halbleiter)zwingend vorhanden, allerdings ist eine solche Isolationsschicht beim Einsatz anderer Transistortypen nicht notwendig und muss daher extra für diese Shunt-Induktivität aufgetragen werden.

Der Erfindung liegt daher die Aufgabe zugrunde, einen Verstärkerbaustein zu schaffen, mit welchem es möglich ist, die parasitäre Ausgangskapazität zu kompensieren, ohne dass dabei spezielle und teure Chipgehäuseformen für den Verstärkerbaustein notwendig sind. Weiterhin soll der erfindungsgemäße Verstärkerbaustein derart ausgestaltet sein, dass Verkopplungen zwischen der Shunt-Induktivität und den Bonddrähten, die den Transistor-Die mit den Ausgangspins verbinden, vermieden werden. Außerdem soll dadurch die Ausgangskapazität des Verstärkerbausteins bestmöglich kompensiert werden, so dass das Anpassnetzwerk mit einer maximalen Bandbreite betrieben werden kann. Schlussendlich soll möglichst keine zusätzliche isolierende Schicht innerhalb des Verstärkerbausteins aufgetragen werden müssen.

Die Aufgabe wird durch einen Verstärkerbaustein mit den Merkmalen des Anspruchs 1 gelöst. Die Unteransprüche enthalten vorteilhafte Weiterbildungen der Erfindung.

Das Kompensationselement dient dabei zur Kompensation der parasitären Ausgangskapazität eines Verstärkerbausteins und weist dazu ein induktives Verhalten auf. Der Verstärkerbaustein selbst besteht aus zumindest zwei Verstärkerelementen, wobei das erfindungsgemäße Kompensationselement außerhalb des Chipgehäuses zwischen zwei mit den Verstärkerelementen verbundenen Anschlusspins durch eine Anschlussfahne ausgebildet ist.

Dadurch, dass das Kompensationselement außerhalb des Chipgehäuses angeordnet ist, muss kein spezielles und teures Chipgehäuse verwendet werden. Weiterhin vereinfacht sich durch den Wegfall des Kompensationselements des Verstärkerbausteins die Anordnung der einzelnen Baugruppen innerhalb des Verstärkergehäuses. Zusätzlich verringert sich die Verkopplung dadurch, dass das Kompensationselement außerhalb und damit entfernt von den Bonddrähten angeordnet ist, die den Transistor-Die mit den Anschlusspins verbinden. Außerdem muss keine isolierende Schicht extra für das als gedruckte Leiterbahn ausgebildete Kompensationselement innerhalb des Verstärkerbausteins aufgetragen werden. Hierdurch wird erreicht, dass die parasitäre Ausgangskapazität zuverlässig kompensiert wird und sich die Bandbreite des Anpassnetzwerks signifikant erhöht und sich gleichzeitig die Kosten für den Verstärkerbaustein reduzieren.

Ein weiterer Vorteil der Erfindung ist, dass die Anschlusspins des Chipgehäuses und das als Anschlussfahne ausgebildete Kompensationselement einteilig ausgeführt sind. Dadurch wird erreicht, dass das Kompensationselement direkt im Fertigungsprozess des Chipgehäuses hinzugefügt werden kann und kein zusätzlicher Lötprozess notwendig ist. Dadurch wird gewährleistet, dass die Induktivität jedes einzelnen Kompensationselements stets gleich groß ist.

Ein weiterer Vorteil der Erfindung besteht, wenn die Anschlusspins des Chipgehäuses eine Biegekante aufweisen. Dadurch kann das Kompensationselement derart gebogen werden, dass sich ein Winkel von bevorzugt 45° bis 135° besonders bevorzugt von 90° zwischen dem Kompensationselement und den Anschlusspins des Chipgehäuses ausbildet. Dadurch werden die Verkopplungen nochmals weiter verringert.

Es ist im Weiteren vorteilhaft, dass das als Anschlussfahne ausgebildete Kompensationselement an einer Abtrennstelle, bzw. an einer Verjüngung von den Anschlusspins des Chipgehäuses abgetrennt werden kann. Dadurch kann derselbe Verstärkerbaustein auch für Anwendungen verwendet werden, bei denen ein solches Kompensationselement Nachteile mit sich bringen würde.

Weiterhin ist vorteilhaft, dass das als Anschlussfahne ausgebildete Kompensationselement verschieden geformt sein kann, um dadurch auf eine einfache Art und Weise verschieden große parasitäre Ausgangskapazitäten zu kompensieren, ohne dass jeweils das Chipdesign geändert werden müsste.

Ein weiterer Vorteil der Erfindung ist, dass sich bei den beiden Verstärkerelementen um Leistungstransistoren, bevorzugt um LDMOS-Transistoren (laterally diffused metal oxide semiconductor; lateral diffundierter Metall-Oxid-Halbleiter) handelt, die in einer sog. Push-Pull-Konfiguration angeordnet sind. Den Drain-Anschlüssen beider Leistungstransistoren wird dabei eine gleich große Versorgungsspannung zugeführt, so dass das Kompensationselement ohne eine zusätzliche Kapazität zur Gleichspannungsentkopplung in Serie zwischen beiden Drain-Anschlüssen angeordnet werden kann, wodurch weitere unerwünschte Resonanzen vermieden werden.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:
- Fig. 1: ein Ersatzschaltplan des Verstärkerbausteins mit dem erfindungsgemäßen Kompensationselement;
- Fig. 2: eine Draufsicht auf den geöffneten Verstärkerbaustein mit dem erfindungsgemäßen Kompensationselement;
- Fig. 3: eine Detailansicht der Abtrennstelle des erfindungsgemäßen Kompensationselements des Verstärkerbausteins;
- Fig. 4: eine Vorderansicht eines ersten Ausführungsbeispiels des Kompensationselements im montierungsbereiten Zustand;
- Fig. 5: eine Vorderansicht eines zweiten Ausführungsbeispiels des Kompensationselements im montierungsbereiten Zustand;
- Fig. 6: eine Vorderansicht eines dritten Ausführungsbeispiels des Kompensationselements im montierungsbereiten Zustand;
- Fig. 7: eine Vorderansicht eines vierten Ausführungsbeispiels des Kompensationselements im montierungsbereiten Zustand;
- Fig. 8: eine Seitenansicht des Verstärkerbausteins mit dem erfindungsgemäßen Kompensationselement im eingebauten Zustand;
- Fig. 9: eine Seitenansicht eines weiteren Ausführungsbeispiels des Verstärkerbausteins mit dem erfindungsgemäßen Kompensationselement im eingebauten Zustand.

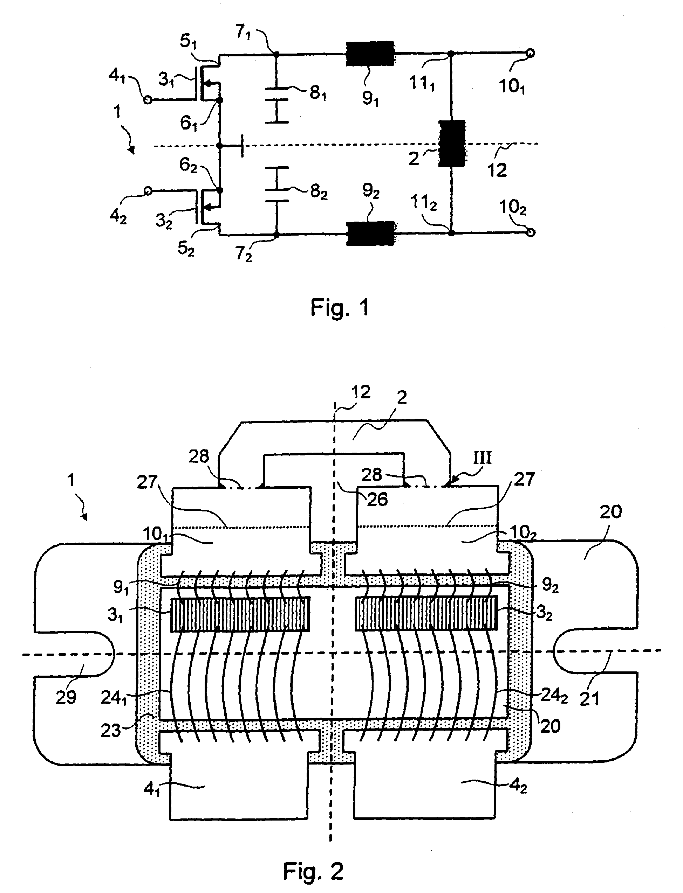

Fig. 1 zeigt einen Schaltplan (Ersatzschaltbild) des Verstärkerbausteins 1 mit dem erfindungsgemäßen Kompensationselement 2. Der Verstärkerbaustein 1 ist spiegelsymmetrisch um die Achse 12 aufgebaut. Der Verstärkerbaustein 1 weist zumindest zwei Verstärkerelemente 3₁, 3₂ auf, die bevorzugt gegenphasig angesteuert werden und in einer push-pull-Konfiguration angeordnet sind. Die Verstärkerelemente 3₁, 3₂ können auch als Transistor-Dies 3₁, 3₂ bezeichnet werden. Der Verstärkerbaustein 1 ist dabei in ein nicht dargestelltes Chipgehäuse eingefasst. Die Verstärkerelemente 3₁, 3₂ weisen bevorzugt zumindest einen Leistungstransistor auf, wobei es sich bevorzugt einen Feldeffekttransistor, insbesondere um einen LDMOS-Transistor (laterally diffused metal oxide semiconductor; lateral diffundierter MetallOxid-Halbleiter) handelt. Dabei ist ein erster Eingangsanschlusskontakt 4₁ bevorzugt mit dem Gate des ersten Verstärkerelements 3₁ verbunden. Ein zweiter Anschluss 5₁ ist bevorzugt mit dem Drain des ersten Verstärkerelements 3₁ verbunden und ein dritter Arischluss 6₁ ist bevorzugt mit dem Source des ersten Verstärkerelements 3₁ verbunden. Weiterhin ist ein erster Eingangsanschlusskontakt 4₂ bevorzugt mit dem Gate eines zweiten Verstärkerelements 3₂ verbunden. Ein zweiter Anschluss 5₂ ist bevorzugt mit dem Drain des zweiten Verstärkerelements 3₂ verbunden und ein dritter Anschluss 6₂ ist bevorzugt mit dem Source des zweiten Verstärkerelements 3₂ verbunden. Die Verstärkerelemente 3₁, 3₂ sind bevorzugt in einer push-pull-Konfiguration angeordnet, so dass ein dritter Anschluss 6₁ eines ersten Verstärkerelements 3₁ mit dem dritten Anschluss 6₂ eines zweiten Verstärkerelements 3₂ verbunden ist. Beide Anschlüsse 6₁, 6₂ sind zusätzlich mit der Bezugsmasse verbunden.

Ein zweiter Anschluss 5₁ eines ersten Verstärkerelements 3₁ ist über den Knoten 7₁ mit einem ersten Anschluss einer Kapazität 8₁ verbunden. Ein zweiter Anschluss dieser Kapazität 8₁ ist mit der Bezugsmasse verbunden. Weiterhin ist ein zweiter Anschluss 5₂ des Verstärkerelements 3₂ über den Knoten 7₂ mit einem ersten Anschluss der Kapazität 8₂ verbunden. Ein zweiter Anschluss der Kapazität 8₂ ist mit der Bezugsmasse verbunden. Beide Kapazitäten 8₁, 8₂ werden durch parasitäre Ausgangskapazitäten 8₁, 8₂ gebildet, die sich zwischen den Drain- und Sourceflächen der Verstärkerelemente 3₁ und 3₂ bilden. Werden diese parasitären Ausgangskapazitäten 8₁ und 8₂ nicht kompensiert, so sinkt die Bandbreite des nicht dargestellten Anpassnetzwerks signifikant.

Der Knoten 7₁ ist weiterhin mit einem ersten Anschluss einer Induktivität 9₁ verbunden. Der zweite Anschluss der Induktivität 9₁ ist mit dem Knoten 11₁ verbunden. Der Knoten 11₁ ist mit dem Anschlusskontakt 10₁ eines nicht dargestellten Chipgehäuses verbunden. Entsprechend dem spiegelsymmetrischen Aufbau um die Achse 12 ist der Knoten 7₂ mit einem ersten Anschluss der Induktivität 9₂ verbunden. Der zweite Anschluss der Induktivität 9₂ ist mit dem Knoten 11₂ verbunden. Der Knoten 11₂ ist mit dem Anschlusskontakt 10₂ des nicht dargestellten Chipgehäuses verbunden. Beide Induktivitäten 9₁ und 9₂ werden durch gedruckte Leiterbahnen und/oder Bonddrähte gebildet, die die zweiten Anschlüsse 5₁, 5₂ der Verstärkerelemente 3₁, 3₂ mit den Anschlusskontakten 10₁, 10₂ des nicht dargestellten Chipgehäuses verbinden.

Eine weitere Induktivität 2 verbindet die beiden Knoten 11₁ und 11₂ und damit die Anschlusskontakte 10₁ und 10₂ des nicht dargestellten Chipgehäuses miteinander. Diese Induktivität 2 ist als Shunt-Induktivität ausgebildet und dient dazu, die parasitären Kapazitäten 8₁, 8₂ für die Betriebsfrequenz zu kompensieren. Diese Induktivität 2, welche auch als das Kompensationselement 2 bezeichnet wird, ist wie im Weiteren noch ausführlich erläutert, als Anschlussfahne 2 zwischen den beiden Anschlusskontakten 10₁ und 10₂ außerhalb des Chipgehäuses ausgebildet. Über das Kompensationselement 2 werden bevorzugt zwei Drain-Anschlüsse der Leistungstransistoren miteinander verbunden. Das Kompensationselement 2 weist dabei ein induktives Verhalten auf.

Durch die Maßnahme, dass das Kompensationselement 2 außerhalb des Verstärkerbausteins 1 angebracht wird, kann die benötigte Chipfläche reduziert werden. Es sind daher keine speziellen Chipgehäuseformen notwendig. Außerdem werden Verkopplungen zwischen dem Kompensationselement 2 mit den Bonddrähten und/oder weiteren gedruckten Leiterbahnen innerhalb des Chipgehäuses vermieden. Dies wirkt sich vorteilhaft auf die erreichbare Bandbreite des Anpassnetzwerks aus. Insgesamt wird der Entwicklungsaufwand reduziert und gleichzeitig werden niedrigere Produktionskosten erzielt.

Dadurch, dass die Verstärkerelemente 3₁, 3₂ in einer push-pull-Konfiguration angeordnet sind und jeweils die zweiten Anschlüsse 5₁ und 5₂ der Verstärkerelemente 3₁, 3₂ mit der gleichen Versorgungsspannung betrieben werden, muss keine weitere Kapazität zur Gleichspannungsentkopplung in Serie zu dem Kompensationselement 2 geschaltet werden, wodurch zusätzliche unerwünschte Resonanzen vermieden werden. Die Versorgungsspannungen an einem ersten Anschluss 4₁, 4₂, der bevorzugt mit dem Gate des Verstärkerelements 3₁, 3₂ verbunden ist, und die Versorgungsspannungen an einem zweiten Anschluss 5₁, 5₂, der bevorzugt mit dem Drain des Verstärkerelements 3₁, 3₂ verbunden ist, sind aus Gründen der Übersichtlichkeit nicht in Fig. 1 eingezeichnet.

Fig. 2 zeigt eine Draufsicht auf den geöffneten Verstärkerbaustein 1 mit dem erfindungsgemäßen Kompensationselement 2. Wie bereits in Fig. 1 gezeigt, ist der Verstärkerbaustein 1 exakt spiegelsymmetrisch entlang der Achse 12 aufgebaut. Der Verstärkerbaustein 1 ist auf einem rechteckigen Grundkörper, bevorzugt auf einem Flansch 20, befestigt, wobei die Ecken des Flanschs 20 abgerundet sind. Entlang der Längsachse 21, die mittig durch den Flansch 20 verläuft und im Mittelpunkt orthogonal zur Achse 12 steht, sind die beiden Einbuchtungen 29 des Flanschs 20 ausgebildet. Über eine nicht dargestellte Fixierung, z.B. eine Schraubverbindung, wird der Flansch 20 auf einem nicht dargestellten Kühlkörper befestigt.

Auf dem Flansch 20 ist eine Isolierschicht 23 ausgebildet. Diese Isolierschicht 23 ist ringförmig ausgebildet, wobei andere Formen ebenfalls denkbar sind. Die Isolierschicht 23 besteht aus einer Keramik oder einem Substrat. Auf dieser Isolierschicht 23 sind parallel zur Längsachse 21 an einem Ende zumindest zwei Eingangsanschlusskontakte 4₁ und 4₂ angeordnet. Ein Teil der Eingangsanschlusskontakte 4₁ und 4₂ steht über der Grundfläche des Flanschs 20 vor. Die Eingangsanschlusskontakte 4₁ und 4₂ sind rechteckförmig oder T-förmig ausgestaltet, wobei beide bevorzugt identisch ausgebildet sind, um dadurch den Fertigungsaufwand zu reduzieren und ein symmetrisches Verhalten zu gewährleisten. Parallel zu den Eingangsanschlusskontakten 4₁ und 4₂ sind auf der gegenüberliegenden Seite des Flanschs 20 die Anschlusskontakte 10₁ und 10₂ angeordnet. Die Anschlusskontakte 10₁ und 10₂ weisen bevorzugt dieselbe Grundfläche auf wie die Eingangsanschlusskontakte 4₁ und 4₂ und sind ebenfalls auf der Isolierschicht 23 ausgebildet.

Parallel zu den Anschlusskontakten 10₁ und 10₂ sind direkt auf dem Flansch 20 die rechteckförmigen Transistor-Dies 3₁, 3₂, bzw. Transistor-Chips 3₁, 3₂ angeordnet. Dabei werden die Transistor-Dies 3₁, 3₂ durch eine Löt- oder Klebeverbindung mit dem Flansch verbunden. Um eine möglichst gute Kompensation der parasitären Kapazitäten 8₁, 8₂ durch das außerhalb des Chipgehäuse angeordnete Kompensationselement 2 zu erreichen, ist darauf zu achten, dass die Transistor-Dies 3₁, 3₂ jeweils möglichst nahe an den Anschlusskontakten 10₁ und 10₂ des Chipgehäuses angeordnet sind. Dadurch wird erreicht, dass die Bonddrähte 9₁, 9₂ einerseits möglichst kurz und damit induktivitätsarm sind und sich andererseits nicht mit der Shunt-Induktivität verkoppeln. Dadurch, dass beide Verstärkerelemente, bzw. Transistor-Dies 3₁, 3₂ direkt mit dem Flansch 20 verbunden sind, wird ein optimaler Wärmeübergang gewährleistet.

Der Eingangsanschlusskontakt 4₁ ist über zumindest einen Bonddraht 24₁ mit dem Transistor-Die 3₁ und dadurch bevorzugt mit dem Gate des Verstärkerelements 3₁ verbunden. Über zumindest einen weiteren Bonddraht 9₁ ist der Anschlusskontakt 10₁ mit dem Transistor-Die 3₁ und dadurch bevorzugt mit dem Drain des Verstärkerelements 3₁ verbunden. Der Source des Verstärkerelements 3₁ ist über die Unterseite des Transistor-Dies 3₁ direkt, bzw. über eine Löt- oder Klebeverbindung mit dem Flansch 20 und dadurch mit der Bezugsmasse verbunden. Genauso verhält es sich für das Verstärkerelement 3₂. Der Eingangsanschlusskontakt 4₂ ist über zumindest einen Bonddraht 24₂ mit dem Transistor-Die 3₂ und dadurch bevorzugt mit dem Gate des Verstärkerelements 3₂ verbunden. Über zumindest einen weiteren Bonddraht 9₂ ist der Anschlusskontakt 10₂ mit dem Transistor-Die 3₂ und dadurch bevorzugt mit dem Drain des Verstärkerelements 3₂ verbunden. Der Source des Verstärkerelements 3₂ ist über die Unterseite des Transistor-Dies 3₂ direkt, bzw. über eine Löt- der Klebeverbindung, mit dem Flansch 20 und dadurch mit der Bezugsmasse und dem Source des Verstärkerelements 3₁ verbunden.

Dadurch, dass bevorzugt LDMOS-Transistoren verwendet werden, kann damit das Transistor-Die 3₁, 3₂ direkt, bzw. über eine Löt- oder Klebeverbindung, auf dem Flansch 20 ausgebildet sein. Der Source des LDMOS-Transistors ist dadurch unmittelbar elektrisch leitend mit dem Flansch 20 verbunden. Eine isolierende Schicht zwischen dem Transistor-Die und dem Flansch, wie in der US 4,107,728 gezeigt, ist daher ist nicht erforderlich, weshalb sich die Herstellungskosten nochmals verringern. Wird das Kompensationselement 2 im Chipgehäuse ausgebildet, so muss eine solche isolierende Schicht auf dem Flansch 20 erst geschaffen werden, was die Produktionskosten wiederum erhöht. wird allerdings das Kompensationselement 2 gemäß der Erfindung außerhalb des Chipgehäuses angeordnet, so kann das Chipdesign dagegen einfach gehalten werden.

Die beiden Anschlusskontakte 10₁ und 10₂ sind über das Kompensationselement 2, welches als Anschlussfahne 2 ausgebildet ist, miteinander verbunden. Die Anschlussfahne 2 ist dabei bügelförmig ausgestaltet. Zwischen der Anschlussfahne 2 und den Anschlusskontakten 10₁ und 10₂ befindet sich eine T-förmige Ausnehmung 26. Zumindest eine Ecke der bügelförmigen Anschlussfahne 2 ist dabei in Ausführungsbeispiel abgeschrägt. Bevorzugt sind dabei die Anschlussfahne 2 und zumindest zwei Anschlusskontakte 10₁ und 10₂ des Chipgehäuses einteilig ausgebildet. Dies wirkt sich vorteilhaft auf den Herstellungsprozess der Anschlussfahne 2 und der beiden Anschlusskontakt 10₁ und 10₂ aus. Diese können bevorzugt in einem einzigen Stanzprozess hergestellt werden. Das als Anschlussfahne 2 ausgebildete Kompensationselement 2 weist dadurch reproduzierbare Werte auf.

Würde das als Anschlussfahne 2 ausgebildete Kompensationselement 2 als separates Bauteil ausgeführt werden, so müsste dieses mittels eines weiteren Lötprozesses mit den Anschlusskontakten 10₁ und 10₂ verbunden werden. Dies müsste nach dem Einbau des Verstärkerbausteins 1 in die Gesamtschaltung erfolgen, wobei die Kompensation der parasitären Kapazitäten 8₁ und 8₂ dabei unterschiedlich gut gelingen würde. Neben erhöhten Produktionskosten würde sich zudem kein Verstärkerbaustein 1 exakt gleich wie der andere verhalten. Dies führt dazu, dass die Bandbreite des nicht dargestellten Anpassnetzwerks stark variiert. Durch die einteilige Ausbildung des Kompensationselements 2 zusammen mit den Anschlusskontakten 10₁, 10₂ kann der Verstärkerbaustein 1 zusammen mit seinem als Anschlussfahne 2 ausgebildeten Kompensationselement 2 automatisch auf einer Platine angeordnet und z.B. in Reflow-Technik verlötet werden.

Weiterhin ist bevorzugt im unteren Drittel von zumindest zwei Anschlusskontakten 10₁ und 10₂ des Chipgehäuses eine Biegekante 27 ausgebildet. Die Biegekante 27 ist in Fig. 2 gepunktet dargestellt. Diese Biegekante 27 entsteht bevorzugt in einem Stanzprozess. Durch die Biegekante 27 kann die Anschlussfahne 2 sehr einfach in einem Winkelbereich von z.B. 45° bis z.B. 135° zu den Anschlusskontakten 10₁ und 10₂ des Chipgehäuses ausgerichtet werden. Bevorzugt wird die Anschlussfahne 2 dabei in einem Winkel von 90° zu den Anschlusskontakten 10₁, 10₂ des Chipgehäuses ausgerichtet. Diese Ausrichtung kann sehr einfach in einem zusätzlichen Montageschritt erreicht werden. Dadurch, dass die Anschlussfahne 2 bevorzugt in einem Winkel von 90° zu den Anschlusskontakten 10₁, 10₂ des Chipgehäuses ausgerichtet ist, kann der Verstärkerbaustein 1 platzsparend in die nicht dargestellte Platine integriert werden. Weitere Bauteile können direkt an den Anschlusskontakten 10₁ und 10₂ platziert werden. Außerdem werden die magnetischen Verkopplungen bei einem Winkel von 90° zwischen der Anschlussfahne 2 und den Bonddrähten 9₁, 9₂ weiter minimiert. Die parasitären Kapazitäten 8₁, 8₂ können dadurch sehr gut kompensiert werden, wodurch sich die Bandbreite des Anpassnetzwerks erhöht. Dadurch, dass die Biegekante im unteren Drittel von den Anschlusskontakten 10₁, 10₂ ausgebildet ist, liegt das Kompensationselement 2 noch näher am Transistor-Die 3₁, 3₂.

Weiterhin ist bevorzugt eine Abtrennstelle 28 ausgebildet, an der die Anschlussfahne 2 von den Anschlusskontakten 10₁, 10₂ des Chipgehäuses abtrennbar ist. Diese Abtrennstelle 28 ist, wie im Weiteren noch erläutert wird, an der Verjüngung zwischen dem Anschlusskontakt 10₁, 10₂ des Chipgehäuses und der Anschlussfahne 2 gebildet. Durch Abtrennen des als Anschlussfahne 2 ausgebildeten Kompensationselements 2 kann der Verstärkerbaustein 1 auch in Anwendungen eingesetzt werden, bei denen eine Verbindung zwischen den Anschlusskontakten 10₁, 10₂ über einen solche Shunt-Induktivität 2 nachteilig wäre. Dies macht den Verstärkerbaustein 1 vielseitig einsetzbar, wobei sich Kosten für die Bevorratung unterschiedlicher Verstärkerbausteine 1 einsparen lassen.

Gut zu sehen ist in Fig. 2, dass der Platzbedarf innerhalb des Verstärkerbausteins 1 deutlich reduziert werden kann, sobald das Kompensationselement 2 außerhalb des Verstärkerbausteins 1 angeordnet ist. Hierdurch können deutlich geringere Bonddrahtlängen und damit eine kleinere parasitäre Serieninduktivitäten 9₁, 9₂ von den Verstärkerelementen 3₁, 3₂ bis zu den Anschlusskontakten 10₁, 10₂ realisiert werden. Dies senkt die Kosten des Verstärkerbausteins 1 und führt neben geringeren magnetischen Verkopplungen dazu, dass der Verstärkerbaustein 1 sehr vielseitig eingesetzt werden kann.

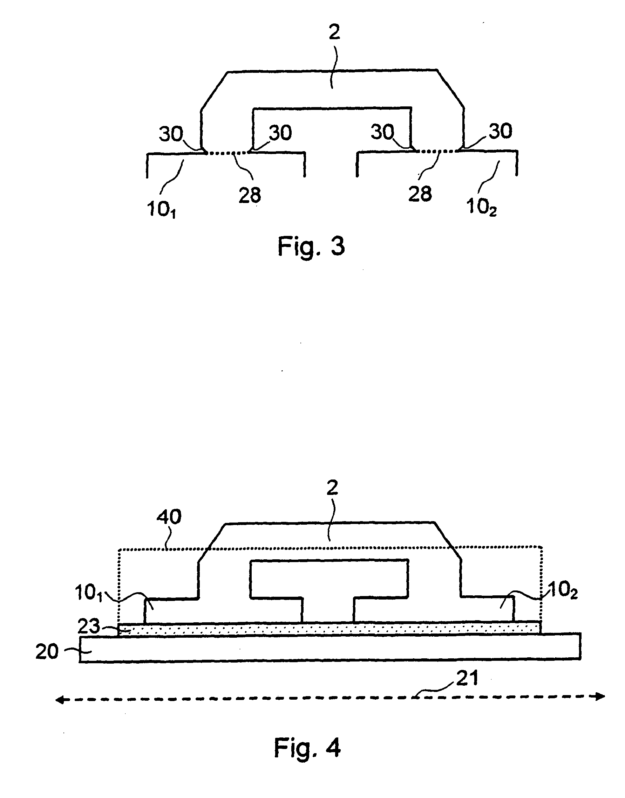

Fig. 3 veranschaulicht nochmals die Möglichkeit, wie die Anschlussfahne 2 von den Anschlusskontakten 10₁, 10₂ abgetrennt werden kann. Hierzu sind an dem Übergang bzw. der Verjüngung zwischen den Anschlusskontakten 10₁, 10₂ und der Anschlussfahne 2 bevorzugt kleine Einkerbungen 30 ausgebildet, die z.B. die Form von Dreiecken oder Schlitzen annehmen. An diesen Einkerbungen 30 kann ein Abtrennwerkzeug, wie z.B. ein Messer oder eine Schere angesetzt werden. Gepunktet dargestellt ist eine Abtrennstelle 28, entlang derer die Anschlussfahne 2 von den Anschlusskontakten 10₁, 10₂ abgetrennt werden kann. Diese Abtrennstelle 28 kann auch perforiert ausgeführt sein, so dass die Anschlussfahne ohne den Einsatz von Abtrennwerkzeugen durch mehrmaliges Biegen entlang der Abtrennstelle 28 abgetrennt werden kann. Ebenfalls ist es möglich, dass die Anschlussfahne 2 durch einen weiteren Stanzprozess abgetrennt werden kann. Dies hat den Vorteil, dass der Verstärkerbaustein 1 auch in Anwendungen eingesetzt werden kann, die kein zusätzliches Kompensationselement 2 erfordern.

Fig. 4 zeigt eine Vorderansicht entlang der Längsachse 21 des Verstärkerbausteins 1 im montierungsbereiten Zustand. Das als Anschlussfahne 2 ausgebildete Kompensationselement 2 ist zusammen mit einem Teil der Anschlusskontakte 10₁, 10₂ an der Biegekante 27 um ca. 90° in Richtung des Deckels des Chipgehäuses 40 nach oben gebogen. Zu sehen ist, wie der Verstärkerbaustein 1 auf dem Flansch 20, welcher als Grundfläche und zur Bezugsmasseanbindung dient, ausgebildet ist. Auf dem Flansch 20 ist als gepunktete Fläche eine ringförmig ausgebildete Isolierschicht 23 dargestellt. Oberhalb der Isolierschicht 23 ist der umgebogene Teil der Anschlusskontakte 10₁, 10₂ und die Anschlussfahne 2 zu sehen. Durch eine gepunktete Linie ist der Deckel des Chipgehäuses 40 des Verstärkerbausteins 1 dargestellt. Zu erkennen ist, dass die Anschlussfahne 2 höher ist als der Deckel des Chipgehäuses 40.

In einem nicht dargestellten Ausführungsbeispiel kann die Anschlussfahne 2 niedriger als der Deckel des Chipgehäuses 40 sein. Die Anschlussfahne weist in Fig. 4 dieselbe bügelförmige Ausbildung auf wie in den Fig. 2 und 3. Die Abtrennstelle 28 aus Fig. 3 ist aus Gründen der Übersichtlichkeit nicht in Fig. 4 eingezeichnet. Gleichwohl ist es auch in Fig. 4 möglich, die Anschlussfahne 2 an der Verjüngung von den Anschlusskontakten 10₁ und 10₂ zu trennen.

Um verschiedene große parasitäre Kapazitäten 8₁, 8₂ durch ein Kompensationselement 2 zu kompensieren, ist es notwendig, dass die Form der Anschlussfahne 2 angepasst werden kann. Denn die Formgebung der Anschlussfahne 2 bestimmt direkt die Induktivität des Korrekturelements 2.

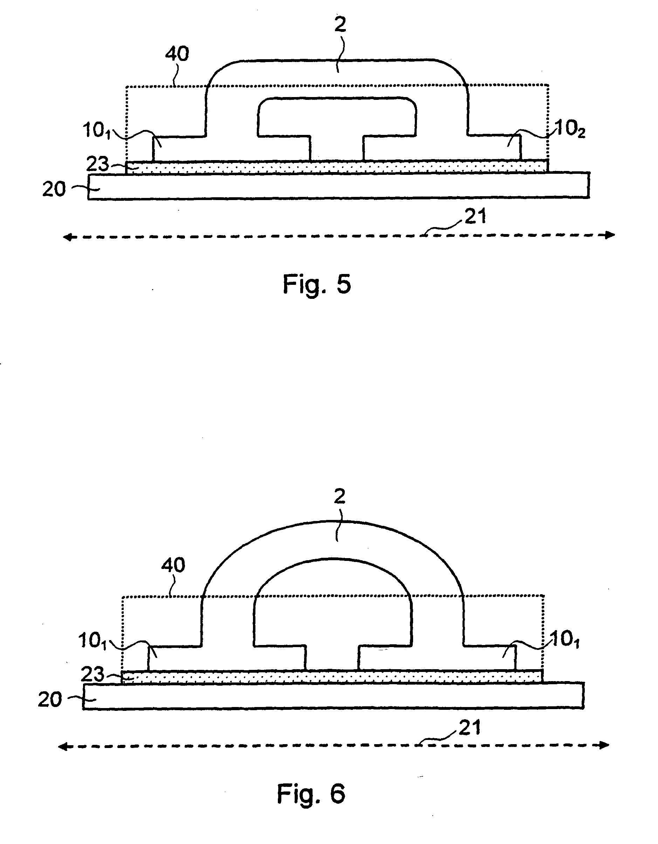

Fig. 5 zeigt wiederum eine Vorderansicht entlang der Längsachse 21 des Verstärkerbausteins 1 im montierungsbereiten Zustand. Das als Anschlussfahne 2 ausgebildete Kompensationselement 2 ist zusammen mit einem Teil der Anschlusskontakte 10₁, 10₂ an der Biegekante 27 um 90° in Richtung des Deckels des Chipgehäuses 40 nach oben gebogen. Zu sehen ist, wie der Verstärkerbaustein 1 auf dem Flansch 20, welcher als Grundfläche und zur Bezugsmasseanbindung dient, ausgebildet ist. Auf dem Flansch 20 ist als gepunktete Fläche eine ringförmig ausgebildete Isolierschicht 23 dargestellt. Oberhalb der Isolierschicht 23 ist der umgebogene Teil der Anschlusskontakte 10₁, 10₂ und die Anschlussfahne 2 zu sehen. Durch eine gepunktete Linie ist der Deckel des Chipgehäuses 40 des Verstärkerbausteins 1 dargestellt. Die Anschlussfahne 2 weist im Gegensatz zu der bekannten Anschlussfahne 2 aus den Fig. 2, 3 und 4 abgerundete Ecken auf.

Das als Anschlussfahne 2 ausgebildete Kompensationselement 2 aus Fig. 5 kann ebenfalls in einem Stanzprozess hergestellt werden. Die Abtrennstelle 28 aus Fig. 3 ist aus Gründen der Übersichtlichkeit nicht in Fig. 5 eingezeichnet. Gleichwohl ist es auch in Fig. 5 möglich, die Anschlussfahne 2 mit den bekannten Methoden von den Anschlusskontakten 10₁ und 10₂ zu trennen.

Fig. 6 zeigt ebenfalls eine Vorderansicht entlang der Längsachse 21 des Verstärkerbausteins 1 im montierungsbereiten Zustand, wobei das Kompensationselement 2 eine weitere Ausbildungsform aufweist. Das als Anschlussfahne 2 ausgebildete Kompensationselement 2 ist zusammen mit einem Teil der Anschlusskontakte 10₁, 10₂ an der Biegekante 27 um 90° in Richtung des Deckels des Chipgehäuses 40 nach oben gebogen. Zu sehen ist, wie der Verstärkerbaustein 1 auf dem Flansch 20, welcher als Grundfläche und zur Bezugsmasseanbindung dient, ausgebildet ist. Auf dem Flansch 20 ist als gepunktete Fläche eine ringförmig ausgebildete Isolierschicht 23 dargestellt. Oberhalb der Isolierschicht 23 ist der umgebogene Teil der Anschlusskontakte 10₁, 10₂ und die Anschlussfahne 2 zu sehen. Durch eine gepunktete Linie ist der Deckel Chipgehäuse 40 des Verstärkerbausteins 1 dargestellt. Die Anschlussfahne 2 weist im Gegensatz zu den bekannten Anschlussfahnen 2 aus den Fig. 2, 3, 4 und 5 eine stark geschwungene Form auf. Die Anschlussfahne 2 kann dabei einen Halbkreis bilden, wobei der Radius so gewählt sein kann, dass das Kompensationselement 2 den Deckel des Chipgehäuses 40 entweder weit überragt oder nicht.

Das als Anschlussfahne 2 ausgebildete Kompensationselement 2 aus Fig. 6 kann ebenfalls in einem Stanzprozess hergestellt werden. Die Abtrennstelle 28 aus Fig. 3 ist aus Gründen der Übersichtlichkeit nicht in Fig. 6 eingezeichnet. Gleichwohl ist es auch in Fig. 6 möglich, die Anschlussfahne 2 mit den bekannten Methoden von den Anschlusskontakten 10₁ und 10₂ zu trennen.

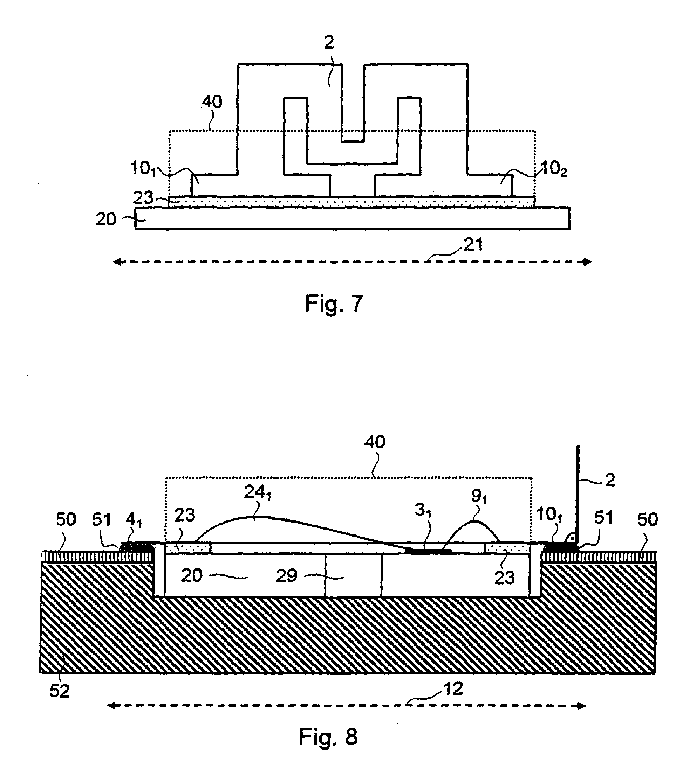

Fig. 7 zeigt ebenfalls eine Vorderansicht entlang der Längsachse 21 des Verstärkerbausteins 1 im montierungsbereiten Zustand, wobei das Kompensationselement 2 eine weitere Ausbildungsform aufweist. Das als Anschlussfahne 2 ausgebildete Kompensationselement 2 ist zusammen mit einem Teil der Anschlusskontakte 10₁, 10₂ an der Biegekante 27 um 90° in Richtung des Deckels des Chipgehäuses 40 nach oben gebogen. Zu sehen ist, wie der Verstärkerbaustein 1 auf dem Flansch 20, welcher als Grundfläche und zur Bezugsmasseanbindung dient, ausgebildet ist. Auf dem Flansch 20 ist als gepunktete Fläche eine ringförmig ausgebildete Isolierschicht 23 dargestellt. Oberhalb der Isolierschicht 23 ist der umgebogene Teil der Anschlusskontakte 10₁, 10₂ und die Anschlussfahne 2 zu sehen. Durch eine gepunktete Linie ist der Deckel des Chipgehäuses 40 des Verstärkerbäusteins 1 dargestellt. Die Anschlussfahne 2 weist im Gegensatz zu den bekannten Anschlussfahnen 2 aus den Fig. 2, 3, 4, 5 und 6 eine mäanderförmige Ausbildung auf. Die Anschlussfahne besteht im Wesentlichen aus drei aneinander gereihten U-förmigen Segmenten, wobei die Ecken jeweils rechtwinklig sind. Durch diese mäanderförmige Ausbildung wird die Induktivität des Kompensationselements 2 vergrößert. Dadurch können in zuverlässiger Weise auch größere parasitäre Kapazitäten 8₁, 8₂ kompensiert werden.

Das als Anschlussfahne 2 ausgebildete Kompensationselement 2 aus Fig. 7 kann ebenfalls in einem Stanzprozess hergestellt werden. Die Abtrennstelle aus Fig. 3 ist aus Gründen der Übersichtlichkeit nicht in Fig. 7 eingezeichnet. Gleichwohl ist es auch in Fig. 7 möglich, die Anschlussfahne 2 mit den bekannten Methoden von den Anschlusskontakten 10₁ und 10₂ zu trennen. In einer weiteren nicht dargestellten Ausführungsform sind die Ecken der mäanderförmig ausgeführten Anschlussfahne 2 abgerundet.

Fig. 8 zeigt eine geschnittene Seitenansicht des Verstärkerbausteins 1 entlang der Achse 12 mit dem erfindungsgemäßen Kompensationselement 2 im eingebauten Zustand. Ein Kühlkörper 52 weist dabei eine rechteckförmige Vertiefung auf. Auf den Kühlkörper 52 ist, mit Ausnahme der rechteckförmigen Vertiefung, eine Platine 50 angebracht. Der Verstärkerbaustein 1, welcher zusammen mit dem erfindungsgemäßen Kompensationselement 2 auf dem Flansch 20 ausgebildet ist, ist in der Vertiefung des Kühlkörpers derart angeordnet, dass über die Einbuchtungen 29 des Flansch 20 dieser z.B. mittels einer nicht dargestellten Schraubverbindung fest mit dem Kühlkörper 52 verbunden ist. Der Kühlkörper 52 weist hierfür entsprechende Bohrungen auf.

Die Verbindung zwischen dem Flansch 20 und dem Kühlkörper 52 muss derart ausgestaltet sein, dass der Wärmewiderstand möglichst klein ist, um die im Betrieb nicht zu vernachlässigende Abwärme, die in einer push-pull-Konfiguration entsteht, sicher aus dem Chipgehäuse 40 zu leiten. Neben einer guten Wärmeleitfähigkeit, muss der Übergang zwischen dem Flansch 20 und dem Kühlkörper 52 auch elektrisch sehr gut leitend sein, weil hierüber ein dritter Anschluss 6₁, 6₂ der Verstärkerelemente 3₁, 3₂ mit der Bezugsmasse verbunden ist. Bevorzugt wird über den Flansch 20 der Source des LDMOS-Transistors mit der Bezugsmasse verbunden.

Weiterhin ist der Eingangsanschlusskontakt 4₁ dargestellt, welcher den Verstärkerbaustein 1 mit der Platine 50 verbindet. Die Platine 50 weist an der Verbindungsstelle mit dem Eingangsanschlusskontakt 4₁ eine nicht dargestellte Kontaktfläche auf, auf welcher mittels einer Dispenser-Einheit ein Lötmittel 51, welches bevorzugt eine pastenartige Konsistenz aufweist, aufgetragen wird. In einem Lötprozess wird der Eingangsanschlusskontakt 4₁ mit der Platine 50 derart verbunden, dass ein niederohmiger elektrischer Kontakt hergestellt ist.

In Fig. 8 ist weiterhin zu sehen, wie der Eingangsanschlusskontakt 4₁ über den Bonddraht 24₁ mit dem Verstärkerelement 3₁, bzw. dem Transistor-Die 3₁ verbunden ist. Das Verstärkerelement 3₁, bzw. der Transistor-Die 3₁ ist dabei über den Bonddraht 9₁ weiterhin mit dem Anschlusskontakt 10₁ verbunden. An dem Anschlusskontakt 10₁ ist wie in den vorangegangenen Figuren dargestellt ein als Anschlussfahne 2 ausgebildetes Kompensationselement 2 ausgebildet. Dieses Kompensationselement 2 ist an einer in Fig. 8 nicht dargestellten Biegekante 27 derart in Richtung des Deckels des Chipgehäuses 40 gebogen, dass sich bevorzugt ein Winkel von ca. 90° zwischen dem als Anschlussfahne 2 ausgebildeten Kompensationselement 2 und dem Anschlusskontakt 10₁ einstellt. Generell kann das Kompensationselement 2 auch in einem anderen Winkel gebogen werden. Ein Winkelbereich von 45° bis 135° kommt hierfür in Frage. Die magnetischen Verkopplungen zwischen dem als Anschlussfahne 2 ausgeführten Kompensationselements 2 und den Bonddrähten 9₁, 9₂ sind allerdings bei einem Winkel von 90° am kleinsten.

Der Anschlusskontakt 10₁ ist mit der Platine 50 verbunden. Die Platine 50 weist hierfür an der Verbindungsstelle mit dem Anschlusskontakt 10₁ eine nicht dargestellte Kontaktfläche auf, auf welcher mittels einer Dispenser-Einheit ein Lötmittel 51, welches bevorzugt eine pastenartige Konsistenz aufweist, aufgetragen wird. In einem Lötprozess wird der Anschlusskontakt 10₁ mit der Platine 50 derart verbunden, dass ein niederohmiger elektrischer Kontakt hergestellt ist.

Zu erkennen ist auch eine Isolierschicht 23, auf welcher der Eingangsanschlusskontakt 4₁ und der Anschlusskontakt 10₁ ausgebildet sind. Das Verstärkerelement 3₁, bzw. der Transistor-Die 3₁ liegt direkt auf dem Flansch 20 auf. Als gepunktete Linie ist der Deckel des Chipgehäuses 40 dargestellt. Eine Platine 50 kann automatisch mit dem Verstärkerbaustein 1 bestückt werden. Lediglich um einen besseren Wärmeübergang und einen besseren elektrischen Kontakt zwischen dem Flansch 20 und dem Kühlkörper 52 zu erreichen, wird bevorzugt zu Beginn des Fertigungsprozesses eine Schraubverbindung eingesetzt. Würde die Schraubverbindung am Ende des Fertigungsprozesses angebracht werden, so würde dies zu mechanischen Verspannungen der Lötstellen führen. Um einen möglichst niederohmigen elektrischen Kontakt zu erreichen, kann der Flansch vergoldet werden. Um eine dauerhafte Festigkeit zwischen den Eingangsanschlusskontakten 4₁, 4₂, bzw. den Anschlusskontakten 10₁, 10₂ und der Platine 50 zu erreichen, sollte hier auf vergoldete Kontakte verzichtet werden. Exakt gleich verhält es sich für die zweite nicht dargestellte Seite mit dem Eingangsanschlusskontakt 4₂; den Bonddrähten 9₂, 24₂, dem Verstärkerelement 3₂, bzw. dem Transistor-Die 3₂ und dem Anschlusskontakt 10₂.

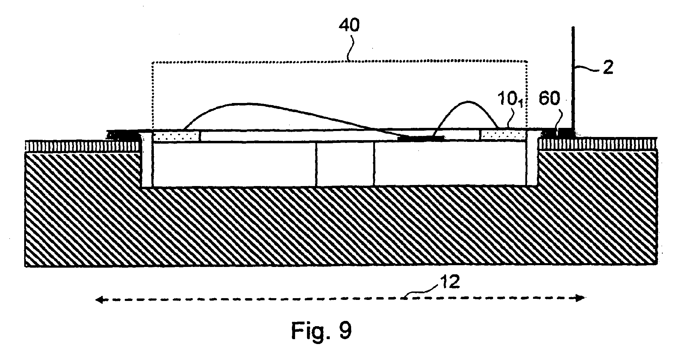

Fig. 9 zeigt in einem weiteren Ausführungsbeispiel eine Seitenansicht des Verstärkerbausteins 1 entlang der Achse 12 mit dem erfindungsgemäßen Kompensationselement 2 im eingebauten Zustand. Der Aufbau und die Funktionsweise des Verstärkerbausteins 1 wurde bereits in den vorangegangenen Figurenbeschreibungen ausführlich erläutert, worauf hiermit verwiesen wird. Der Unterschied zwischen Fig. 9 und Fig. 8 besteht darin, dass der Anschlusskontakt 10₁ in Fig. 9 eine hohlkehlenartige Ausbildung 60 aufweist, deren Öffnung in Richtung des Chipgehäuses 40 zeigt. Die hohlkehlenartige Ausbildung 60 weist dabei eine Tiefe auf, die im Bereich von z.B. unter einem Millimeter bis hin zu zumindest einem Millimeter liegt. Die hohlkehlenartige Ausbildung 60 kann durch einen Stanzprozess im Anschlusskontakt 10₁ gebildet werden, wodurch im Lötprozess eine höhere Verbindungsfestigkeit erreicht wird. Dieselbe hohlkehlenartige Ausbildung 60 liegt auch im nicht dargestellten Anschlusskontakt 10₂ vor. Weiterhin können auch die Eingangsanschlusskontakte 4₁ und 4₂ mit einer solchen hohlkehlenartigen Ausbildung 60 versehen sein.

Die Erfindung ist nicht auf die dargestellten Ausführungsbeispiele beschränkt. Alle beschriebenen und/oder gezeichneten Elemente sind im Rahmen der Erfindung beliebig miteinander kombinierbar. Beispielsweise können auch bipolare Transistoren zum Einsatz kommen.

## Patentansprüche

1. Verstärkerbaustein (1) mit einem Gehäuse (40) und zumindest zwei Verstärkerelementen (3₁, 3₂),
wobei sich zwischen zumindest zwei Anschlüssen (5₁, 5₂ und 6₁, ₆2) jedes Verstärkerelements (3₁, 3₂) eine parasitäre Kapazität (8₁, 8₂) ausbildet und
wobei diese parasitäre Kapazität (8₁, 8₂) durch ein induktives Kompensationselement (2) kompensiert ist,
**dadurch gekennzeichnet,**
**dass** das Kompensationselement (2) zwischen zwei Anschlusskontakten (10₁, 10₂) außerhalb des Gehäuses (40) durch eine Anschlussfahne (2) ausgebildet ist.

2. Verstärkerbaustein nach Anspruch 1,
**dadurch gekennzeichnet,**
**dass** eine Formgebung der Anschlussfahne (2) die Induktivität des Kompensationselements (2) bestimmt.

3. Verstärkerbaustein nach Anspruch 1 oder 2,
**dadurch gekennzeichnet,**
**dass** zumindest zwei Anschlusskontakten (10₁, 10₂) des Gehäuses (40) eine Biegekante (27) aufweisen.

4. Verstärkerbaustein nach Anspruch 3,
**dadurch gekennzeichnet,**
**dass** die Anschlussfahne (2) an der Biegekante (27) in einem Winkelbereich von 45° bis 135°, bevorzugt etwa 90°, zu den Anschlusskontakten (10₁, 10₂) des Gehäuses (40) abgewinkelt ist.

5. Verstärkerbaustein nach einem der Ansprüche 1 bis 4,
**dadurch gekennzeichnet,**
**dass** die Anschlussfahne (2) und die zwei Anschlusskontakte (10₁, 10₂) des Gehäuses (40) einteilig ausgebildet sind.

6. Verstärkerbaustein nach Anspruch 5,
**dadurch gekennzeichnet,**
**dass** die Anschlussfahne (2) und die Anschlusskontakte (10₁, 10₂) zusammen in einem Stanzprozess hergestellt sind.

7. Verstärkerbaustein nach Anspruch 5 oder 6,
**dadurch gekennzeichnet,**
**dass** eine Abtrennstelle (28) vorhanden ist, an der die Anschlussfahne (2) von den Anschlusskontakten (10₁, 10₂) des Gehäuses (40) abtrennbar ist.

8. Verstärkerbaustein nach einem der Ansprüche 1 bis 7,
**dadurch gekennzeichnet,**
**dass** die Anschlussfahne (2) bügelförmig ausgestaltet ist.

9. Verstärkerbaustein nach einem der Ansprüche 1 bis 7,
**dadurch gekennzeichnet,**
**dass** die Anschlussfahne (2) geschwungen ausgeführt ist.

10. Verstärkerbaustein nach einem der Ansprüche 1 bis 7,
**dadurch gekennzeichnet,**
**dass** die Anschlussfahne (2) mäanderförmig ausgeführt ist.

11. Verstärkerbaustein nach einem der Ansprüche 1 bis 10,
**dadurch gekennzeichnet,**
**dass** der Anschlusskontakt (10₁, 10₂) eine hohlkehlenartige Ausbildung (60) aufweist, um dadurch im Lötprozess eine hohe Verbindungsfestigkeit zu erreichen.

12. Verstärkerbaustein nach einem der Ansprüche 1 bis 11,
**dadurch gekennzeichnet,**
**dass** die Verstärkerelemente (3₁, 3₂) nahe zu den Anschlusskontakten (10₁, 10₂) des Gehäuses (40) angeordnet sind.

13. Verstärkerbaustein nach Anspruch 12,
**dadurch gekennzeichnet,**
**dass** die Verstärkerelemente (3₁, 3₂) direkt mit einem Flansch (20) verbunden sind.

14. Verstärkerbaustein nach einem der Ansprüche 1 bis 13,
**dadurch gekennzeichnet,**
**dass** beide Verstärkerelemente (3₁, 3₂) gegenphasig angesteuert werden und in einer push-pull-Konfiguration angeordnet sind.

15. Verstärkerbaustein nach einem der Ansprüche 1 bis 14,
**dadurch gekennzeichnet,**
**dass** es sich bei den Verstärkerelementen (3₁, 3₂) um Transistor-Dies (3₁, 3₂) handelt und jeder Transistor-Die (3₁, 3₂) zumindest einen Leistungstransistor, bevorzugt einen LDMOS-Transistor, aufweist.

16. Verstärkerbaustein nach Anspruch 15,
**dadurch gekennzeichnet,**
**dass** zwei Drain-Anschlüsse (5₁, 5₂) der beiden Leistungstransistoren über das Kompensationselement (2) miteinander verbunden sind.

## Claims

1. Amplifier component (1) with a housing (40) and at least two amplifier elements (3₁, 3₂),
wherein a parasitic capacitance (8₁, 8₂) is formed between at least two connections (5₁, 5₂ and 6₁, 6₂) of each amplifier element (3₁, 3₂), and
wherein this parasitic capacitance (8₁, 8₂) is compensated by an inductive compensation element (2),
**characterised in that**
the compensation element (2) is formed by a connecting lug (2) between two connecting contacts (10₁, 10₂) outside the housing (40).

2. Amplifier component according to claim 1,
**characterised in that**
the shaping of the connecting lug (2) determines the inductance of the compensation element (2).

3. Amplifier component according to claim 1 or 2,
**characterised in that**
at least two connecting contacts (10₁, 10₂) of the housing (40) exhibit a bending edge (27).

4. Amplifier component according to claim 3,
**characterised in that**
the connecting lug (2) is angled at the bending edge (27) in an angle range of from 45° to 135°, preferably approximately 90°, relative to the connecting contacts (10₁, 10₂) of the housing (40).

5. Amplifier component according to one of claims 1 to 4,
**characterised in that**
the connecting lug (2) and the two connecting contacts (10₁, 10₂) of the housing (40) are formed in one piece.

6. Amplifier component according to claim 5,
**characterised in that**
the connecting lug (2) and the connecting contacts (10₁, 10₂) are manufactured together in a punching process.

7. Amplifier component according to claim 5 or 6,
**characterised in that**
a break-off point (28) is present at which the connecting lug (2) can be detached from the connecting contacts (10₁, 10₂) of the housing (40).

8. Amplifier component according to one of claims 1 to 7,
**characterised in that**
the connecting lug (2) is designed in the shape of a bow.

9. Amplifier component according to one of claims 1 to 7,
**characterised in that**
the connecting lug (2) is curved.

10. Amplifier component according to one of claims 1 to 7,
**characterised in that**
the connecting lug (2) is meander shaped.

11. Amplifier component according to one of claims 1 to 10, **characterised in that** the connecting contact (10₁, 10₂) exhibits a groove-like form (60) in order to achieve a high connection strength in the soldering process.

12. Amplifier component according to one of claims 1 to 11, **characterised in that** the amplifier elements (3₁, 3₂) are arranged close to the connecting contacts (10₁, 10₂) of the housing (40).

13. Amplifier component according to claim 12,
**characterised in that**
the amplifier elements (3₁, 3₂) are connected directly to a flange (20).

14. Amplifier component according to one of claims 1 to 13, **characterised in that** the two amplifier elements (3₁, 3₂) are actuated in phase opposition and arranged in a push-pull configuration.

15. Amplifier component according to one of claims 1 to 14, **characterised in that** the amplifier elements (3₁, 3₂) are transistor dies (3₁, 3₂) and each transistor die (3₁, 3₂) exhibits at least one power transistor, preferably an LDMOS transistor.

16. Amplifier component according to claim 15,
**characterised in that**
two drain connections (5₁, 5₂) of the two power transistors are connected to one another via the compensation element (2).

## Revendications

1. Composant amplificateur (1) comportant un boîtier (40) et au moins deux éléments amplificateurs (3₁, 3₂),
dans lequel une capacité parasite (8₁, 8₂) se forme entre au moins deux connexions (5₁, 5₂ et 6₁, 6₂) de chaque élément amplificateur (3₁, 3₂) et
dans lequel cette capacité parasite (8₁, 8₂) est compensée par un élément de compensation inductif (2),
**caractérisé en ce que**
l'élément de compensation (2) est formé par une languette de connexion (2) entre deux contacts de connexion (10₁, 10₂) à l'extérieur du boîtier (40).

2. Composant amplificateur selon la revendication 1, **caractérisé en ce que**
la réalisation de la languette de connexion (2) détermine l'inductivité de l'élément de compensation (2).

3. Composant amplificateur selon la revendication 1 ou 2, **caractérisé en ce que**
au moins deux contacts de connexion (10₁, 10₂) du boîtier (40) présentent une arête de pliage (27).

4. Composant amplificateur selon la revendication 3, **caractérisé en ce que**
la languette de connexion (2) est pliée sur l'arête de pliage (27) dans une plage angulaire de 45° à 135°, de préférence environ 90°, vers les contacts de connexion (10₁, 10₂) du boîtier (40).

5. Composant amplificateur selon l'une des revendications 1 à 4, **caractérisé en ce que**
la languette de connexion (2) et les deux contacts de connexion (10₁, 10₂) du boîtier (40) sont réalisés d'une seule pièce.

6. Composant amplificateur selon la revendication 5, **caractérisé en ce que**
la languette de connexion (2) et les contacts de connexion (10₁, 10₂) sont réalisés conjointement lors d'un processus de découpe.

7. Composant amplificateur selon la revendication 5 ou 6, **caractérisé en ce que**
une position de séparation (28) est prévue, à laquelle la languette de connexion (2) peut être séparée des contacts de connexion (10₁, 10₂) du boîtier (40).

8. Composant amplificateur selon l'une des revendications 1 à 7, **caractérisé en ce que**
la languette de connexion (2) est réalisée en forme d'étrier.

9. Composant amplificateur selon l'une des revendications 1 à 7, **caractérisé en ce que**
la languette de connexion (2) est réalisée oscillante.

10. Composant amplificateur selon l'une des revendications 1 à 7, **caractérisé en ce que**
la languette de connexion (2) est réalisée sous la forme d'un méandre.

11. Composant amplificateur selon l'une des revendications 1 à 10, **caractérisé en ce que**
le contact de connexion (10₁, 10₂) est réalisé en forme de gorge (60), afin d'atteindre une stabilité de liaison élevée lors du processus de soudage.

12. Composant amplificateur selon l'une des revendications 1 à 11, **caractérisé en ce que**
les éléments amplificateurs (3₁, 3₂) sont disposés près des contacts de connexion (10₁, 10₂) du boîtier (40).

13. Composant amplificateur selon la revendication 12, **caractérisé en ce que**
les éléments amplificateurs (3₁, 3₂) sont reliés directement à une collerette (20).

14. Composant amplificateur selon l'une des revendications 1 à 13, **caractérisé en ce que**
deux éléments amplificateurs (3₁, 3₂) sont commandés en opposition de phase et sont agencés selon une configuration push-pull.

15. Composant amplificateur selon l'une des revendications 1 à 14, **caractérisé en ce que**
dans le cas des éléments amplificateurs (3₁, 3₂), il s'agit de puces de transistor (3₁, 3₂) et chaque puce de transistor (3₁, 3₂) présente au moins un transistor de puissance, de préférence un transistor LDMOS.

16. Composant amplificateur selon la revendication 15, **caractérisé en ce que**
deux connexions de drain (5₁, 5₂) des deux transistors de puissance sont reliées l'une à l'autre par l'intermédiaire de l'élément de compensation (2).
